(19) Europäisches Patentamt / European Patent Office / Office européen des brevets

(11) **EP 2 533 428 A1**

(12) **DEMANDE DE BREVET EUROPEEN**

(43) Date de publication:
**12.12.2012 Bulletin 2012/50**

(51) Int Cl.:
*H04B 1/04* *(2006.01)*  *H03F 1/32* *(2006.01)*

(21) Numéro de dépôt: **12162528.9**

(22) Date de dépôt: **30.03.2012**

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**
Etats d'extension désignés:
**BA ME**

(30) Priorité: **07.06.2011 FR 1154922**

(71) Demandeur: **STmicroelectronics SA**
**92120 Montrouge (FR)**

(72) Inventeurs:
  • **Delaunay, Nicolas**
    **38000 Grenoble (FR)**

  • **Kerherve, Eric**
    **33400 Talence (FR)**
  • **Deltimple, Nathalie**
    **33600 Pessac (FR)**
  • **Belot, Didier**
    **38140 Rives (FR)**

(74) Mandataire: **de Beaumont, Michel et al**
    **Cabinet Beaumont**
    **1, rue Champollion**
    **38000 Grenoble (FR)**

(54) **Emetteur sans fil multistandard**

(57)      L'invention concerne un circuit d'émission RF sans fil multistandard comprenant : un circuit d'entrée (302 à 314) pour générer un signal d'émission ($I_T(t)$, $Q_T(t)$) sur la base d'un signal de données d'entrée (I, Q) ; un amplificateur de puissance (316) adapté à amplifier le signal d'émission pour obtenir un signal de sortie ($S(t)$) pour émission par l'intermédiaire d'au moins une antenne ; et un circuit de contre-réaction (320 à 340) comprenant au moins un filtre passe-bas variable (334, 336) pour générer un signal de contre-réaction ($I_{FB}$, $Q_{FB}$) sur la base du signal de sortie, dans lequel le circuit d'entrée comprend en outre un circuit de pré-distorsion (302) adapté à modifier le signal de données d'entrée (I, Q) sur la base du signal de contre-réaction.

EP 2 533 428 A1

**Description**

Domaine de l'invention

La présente invention concerne le domaine des transmissions sans fil, et plus particulièrement un dispositif et un procédé d'émission sans fil RF (radiofréquence) multistandard.

Arrière plan de l'invention

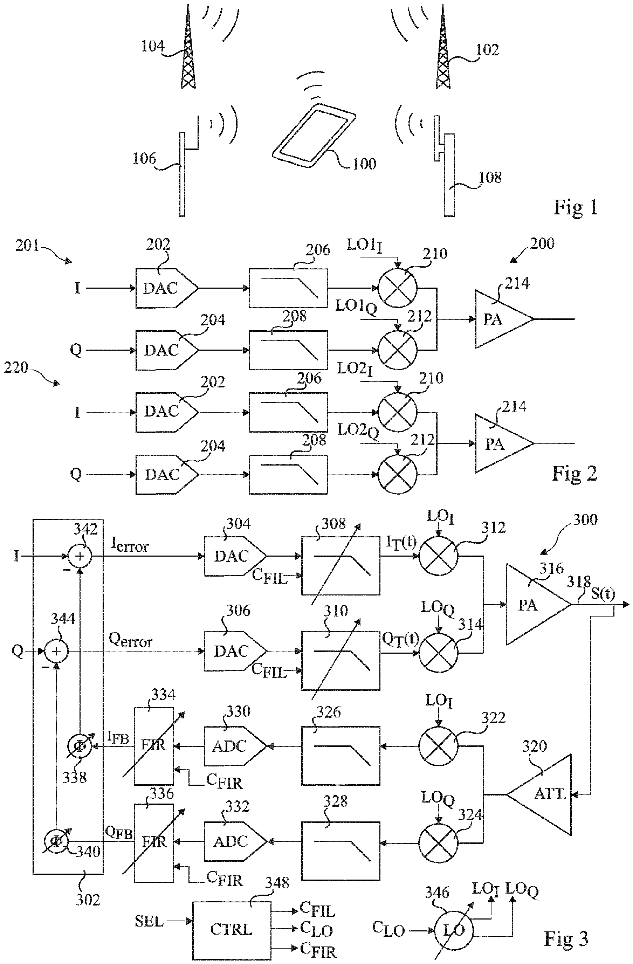

La figure 1 illustre un dispositif mobile 100, qui peut par exemple communiquer selon un certain nombre de normes de communication différentes par l'intermédiaire d'un certain nombre d'antennes-relais de réseau mobile 102, 104, 106 et 108. Par exemple, des régions différentes peuvent comprendre des infrastructures de communication basées sur des normes de communication différentes. Dans l'exemple de la figure 1, l'antenne-relais 102 d'une région donnée supporte par exemple des communications selon la norme GSM (système global pour des communications mobiles), l'antenne-relais 104 d'une autre région supporte par exemple des communications selon la norme UMTS (système de télécommunication mobile universel), l'antenne-relais 106 d'une autre région supporte par exemple des communications selon la norme WiMax (interopérabilité mondiale pour accès micro-ondes), et l'antenne-relais 108 supporte par exemple des communications selon la norme LTE (Evolution à Long Terme). Il est souhaitable que le dispositif mobile 100 puisse communiquer par l'intermédiaire de l'une quelconque des antennes-relais de réseau mobile 102 à 108, et donc qu'il soit capable de communications selon toutes les normes.

Chacune des normes de communication mobile est par exemple associée à une fréquence de transmission différente. Par exemple, des communications selon la norme GSM peuvent être transmises à des fréquences de 900 MHz ou 1,8 GHz, des communications selon la norme UMTS à 1,95 GHz, des communications selon la norme WiMax à 2,7 ou 3,5 GHz, et des communications selon la norme LTE à 4,5 GHz. Ainsi, pour pouvoir supporter plus d'une des normes de communications susmentionnées, les circuits de transmission présents dans le dispositif mobile 100 doivent être capables de transmissions à l'une quelconque des fréquences associées.

La figure 2 illustre un exemple de circuit d'émission multistandard 200 du dispositif mobile 100.

Un signal de données à émettre a été modulé pour obtenir des composantes en phase et en quadrature I et Q.

Ces signaux de données I et Q sont fournis à une première branche d'émission 201, et en particulier à des convertisseurs numérique-analogique (DAC) 202 et 204, dont les sorties sont couplées à des filtres passe-bas correspondants 206 et 208. Les sorties des filtres 206 et 208 sont à leur tour couplées à des mélangeurs correspondants 210 et 212, qui réalisent une élévation en fréquence des signaux de données analogiques I et Q filtrés, en les multipliant par des signaux de fréquence correspondants $LO1_I$ et $LO1_Q$, respectivement. Les sorties des mélangeurs 210 et 212 sont combinées et fournies à un amplificateur de puissance 214, qui amplifie le signal pour fournir un signal RF pour émission par l'intermédiaire d'une antenne (non illustrée en figure 2) du dispositif mobile 100.

En outre, les signaux de données I et Q sont fournis à une deuxième branche d'émission 220, qui comprend les mêmes composants que la première branche d'émission 201, mais dans laquelle les mélangeurs 210, 212 multiplient les signaux de données numériques filtrés par des signaux de fréquence $LO2_I$ et $LO2_Q$ respectivement, différents des signaux $LO1_I$ et $LO1_Q$.

La branche d'émission 201 prend en charge une certaine norme de communication, tandis que la branche d'émission 220 prend en charge une autre norme. Ainsi, les filtres 206, 208, les fréquences porteuses et les amplificateurs de puissance 214 de chaque branche 201, 220 sont par exemple choisis en fonction de la norme particulière à prendre en charge.

Un inconvénient du circuit d'émission 200 est qu'il est coûteux en termes de surface de silicium en raison des deux branches d'émission, et que le coût est encore supérieur si on l'étend à la prise en charge de plus de deux normes, en ajoutant des branches d'émission supplémentaires.

Résumé de l'invention

Un objet de la présente invention est de résoudre au moins partiellement un ou plusieurs problèmes de l'art antérieur.

Selon un aspect de la présente invention, on prévoit un circuit d'émission RF sans fil multistandard comprenant : un circuit d'entrée pour générer un signal d'émission sur la base d'un signal de données d'entrée ; un amplificateur de puissance adapté à amplifier le signal d'émission pour fournir un signal de sortie pour émission par l'intermédiaire d'au moins une antenne ; et un circuit de contre-réaction comprenant au moins un filtre passe-bas variable pour générer un signal de contre-réaction sur la base du signal de sortie, le circuit d'entrée comprenant en outre un circuit de pré-distorsion adapté à modifier le signal de données d'entrée sur la base du signal de contre-réaction.

Selon un mode de réalisation, le circuit comprend en outre un circuit de commande adapté à contrôler une fréquence de coupure dudit au moins un filtre passe-bas variable sur la base d'une norme de communication sélectionnée pour l'émission RF sans fil.

Selon un autre mode de réalisation, le circuit comprend en outre un oscillateur variable pour générer au moins un signal de fréquence sur la base d'une norme de communication sélectionnée pour l'émission RF sans fil, et le circuit d'entrée comprend en outre au moins un mélangeur adapté à réaliser une élévation en fréquence du signal de données d'entrée modifié sur la base dudit signal de fréquence pour générer le signal d'émission ; et le circuit de contre-réaction comprend en outre au moins un mélangeur adapté à réaliser un abaissement de fréquence du signal d'émission avant le filtrage par le filtre passe-bas.

Selon un autre mode de réalisation, ledit au moins un filtre passe-bas variable est un filtre numérique.

Selon un autre mode de réalisation, le signal de données d'entrée comprend une composante en phase et une composante en quadrature.

Selon un autre mode de réalisation, le circuit d'entrée comprend en outre au moins un convertisseur numérique-analogique pour convertir le signal de données d'entrée modifié, et le circuit de contre-réaction comprend au moins un convertisseur analogique-numérique pour convertir le signal de sortie avant le filtrage par le filtre passe-bas.

Selon un autre mode de réalisation, le circuit d'entrée comprend en outre au moins un filtre passe-bas variable analogique adapté à filtrer le signal de données d'entrée modifié.

Selon un autre mode de réalisation, le circuit de contre-réaction comprend en outre au moins un filtre passe-bas analogique à fréquence de coupure fixe pour filtrer le signal de sortie avant le filtrage par le filtre passe-bas variable.

Selon un autre mode de réalisation, le circuit de contre-réaction comprend en outre un atténuateur adapté à atténuer le signal de sortie avant le filtrage par le filtre passe-bas variable.

Selon un autre mode de réalisation, le circuit de pré-distorsion comprend en outre au moins un déphaseur pour modifier la phase du signal de contre-réaction, et au moins un soustracteur adapté à soustraire le signal de contre-réaction à phase modifiée du signal de données d'entrée.

Selon un autre mode de réalisation, ledit au moins un filtre passe-bas variable du circuit de contre-réaction est un filtre FIR (à réponse impulsionnelle finie).

Selon un autre aspect de la présente invention, on prévoit un dispositif mobile comprenant : un bloc processeur ; et un circuit émetteur-récepteur comprenant le circuit susmentionné, le bloc processeur étant agencé pour générer un signal de sélection indiquant une norme de communication sélectionnée pour la transmission RF sans fil.

Selon un mode de réalisation, le dispositif mobile comprend en outre au moins une antenne agencée pour émettre le signal de sortie.

Selon encore un autre aspect de la présente invention, on prévoit un procédé d'émission RF sans fil multistandard comprenant les étapes suivants générer, par un circuit d'entrée, un signal d'émission sur la base d'un signal de données d'entrée ; amplifier le signal d'émission par un amplificateur de puissance pour fournir un signal de sortie pour émission par l'intermédiaire d'au moins une antenne ; générer, par au moins un filtre passe-bas variable, un signal de contre-réaction sur la base du signal de sortie ; et modifier, par un circuit de pré-distorsion, le signal de données d'entrée sur la base du signal de contre-réaction.

Selon un mode de réalisation, le procédé comprend en outre le contrôle d'une fréquence de coupure dudit au moins un filtre passe-bas variable sur la base d'une norme de communication sélectionnée pour l'émission RF sans fil.

Brève description des dessins

Les objets, fonctionnalités, aspects et avantages susmentionnés, et d'autres, de l'invention apparaîtront clairement à la lecture de la description détaillée suivante de modes de réalisation particuliers, donnée à titre d'illustration et non de limitation, en référence aux dessins joints, dans lesquels :

la figure 1 (décrite précédemment) illustre un dispositif mobile multistandard selon un exemple ;
la figure 2 (décrite précédemment) illustre un circuit d'émission selon un exemple ;
la figure 3 illustre un circuit d'émission selon un mode de réalisation de la présente invention ;
la figure 4 est un graphique représentant des caractéristiques de filtres de la figure 3 selon un mode de réalisation de la présente invention ;
la figure 5 illustre plus en détail une partie numérique du circuit de la figure 3 selon un mode de réalisation de la présente invention ; et
la figure 6 illustre un dispositif mobile selon un mode de réalisation de la présente invention.

Description détaillée des modes de réalisation de la présente invention

La figure 3 illustre un circuit d'émission multistandard 300 selon un mode de réalisation. Le circuit 300 est par exemple mis en oeuvre dans le dispositif mobile 100, permettant une émission de données selon deux, ou plus, normes de communication différentes. Par exemple, certaines des normes GSM, UMTS, WiMax et LTE, ou d'autres encore, sont prises en charge.

Le circuit 300 comprend un bloc numérique 302, qui reçoit des signaux de données en phase et en quadrature I et Q. En particulier, les signaux de données I et Q sont par exemple générés par des sinusoïdes de modulation respective, qui sont déphasées entre elles de 90°. La modulation utilisée pour moduler les signaux de données I et Q pourrait être de l'un quelconque d'un certain nombre de types. Selon la norme GSM, la modulation est par exemple de type GMSK (modulation à déplacement minimum Gaussien). Selon la norme UMTS, la modulation est par exemple de type QAM (modulation d'amplitude en quadrature), 16 QAM, PSK (modulation par déplacement de phase) ou plus particulièrement HPSK (PSK hybride). Selon la norme WiMax, la modulation est par exemple QAM ou 16 QAM. Selon la norme LTE, la modulation est par exemple une modulation SC (à porteuse unique) dans le sens montant et une modulation MC (à porteuses multiples) dans le sens descendant. A titre de variante, on pourrait aussi utiliser d'autres types de modulation.

Sur la base des signaux de données I et Q, et d'un signal de contre-réaction décrit plus en détail ci-après, le circuit numérique 302 génère des signaux d'erreur $I_{error}$ et $Q_{error}$, fournis à des convertisseurs numérique-analogique (DAC) respectifs 304 et 306. Les sorties des DAC 304, 306 sont fournies à des filtres passe-bas variables respectifs 308, 310, qui filtrent les signaux analogiques pour générer des signaux d'émission $I_T(t)$ et $Q_T(t)$ respectivement. En particulier, chacun des filtres passe-bas 308, 310 reçoit un signal de commande $C_{FIL}$, contrôlant leurs fréquences de coupure, comme on va le décrire plus en détail ci-après. Par exemple, des filtres passe-bas variables sont décrits plus en détail dans la publication IEEE intitulée "A CMOS Active-RC Low Pass Filter With Simultaneous Tunable High- and Low-cutoff Frequencies for IEEE 802.22 Applications", H. Shin et al., dont le contenu est considéré ici comme connu. Les sorties des filtres passe-bas 308, 310 sont fournies à des mélangeurs correspondants 312, 314, qui multiplient les signaux par des signaux de fréquence $LO_I$ et $LO_Q$, respectivement, pour réaliser une élévation de fréquence vers la plage des fréquences d'émission. Les signaux de fréquence $LO_I$ et $LO_Q$ sont par exemple des signaux sinusoïdaux déphasés entre eux de 90°. Les sorties des mélangeurs 312, 314 sont combinées, et couplées à l'entrée d'un amplificateur de puissance (PA) 316, qui amplifie le signal pour fournir un signal de sortie S(t) sur une ligne 318 pour émission par l'intermédiaire d'une ou plusieurs antennes (non illustrées en figure 3). Par exemple, le gain de l'amplificateur de puissance est compris entre 10 et 20 dB.

Un signal de contre-réaction est prélevé sur la ligne de sortie 318, et est fourni à un atténuateur (ATT) 320, qui atténue le signal, par exemple entre 3 et 6 dB. La sortie de l'atténuateur 320 est fournie à des mélangeurs 322 et 324, qui multiplient le signal atténué par les signaux de fréquence $LO_I$ et $LO_Q$ respectivement pour réaliser un abaissement de fréquence. Les sorties des mélangeurs 322 et 324 sont fournies à des filtres passe-bas 326 et 328 respectivement, qui sont par exemple des filtres du premier ordre ayant une fréquence de coupure fixe, comme cela va être décrit plus en détail ci-après. Les sorties des filtres 326, 328 sont fournies à des convertisseurs analogique-numérique (ADC) 330, 332 respectivement, pour générer des signaux numériques. Ces signaux numériques sont filtrés par des filtres FIR (à réponse impulsionnelle finie) respectifs 334, 336, pour obtenir des signaux de contre-réaction numérique $I_{FB}$ et $Q_{FB}$ respectivement. En particulier, chacun des filtres 334, 336 comprend par exemple un certain nombre d'étages dont chacun est associé à un coefficient de filtre correspondant, et comporte une entrée pour recevoir un signal de commande $C_{FIR}$ pour ajuster un ou plusieurs de ces coefficients afin de faire varier la fréquence de coupure des filtres. Par exemple, de tels filtres FIR variables sont décrits plus en détail dans la publication intitulée "GUI Based Decimation Filter Design Tool for Multi-Standard Wireless Transceivers", T.K. Shahanna et al., dont le contenu est considéré ici comme connu. Les sorties des filtres FIR variables 334, 336 sont couplées à des entrées correspondantes du bloc numérique 302.

Le bloc numérique 302 comprend par exemple des déphaseurs 338, 340, qui appliquent une rotation de phase variable aux signaux de contre-réaction $I_{FB}$, $Q_{FB}$, avant de fournir ces signaux à des soustracteurs 342, 344, respectivement, qui soustraient les signaux de contre-réaction $I_{FB}$, $Q_{FB}$ des signaux 1 et Q respectivement, afin de générer les signaux d'erreur $I_{error}$ et $Q_{error}$.

Le signal de fréquence $LO_I$ fourni aux mélangeurs 312, 322, et le signal de fréquence $LO_Q$ fourni aux mélangeurs 314, 324, sont par exemple fournis par un oscillateur local variable 346, sur la base d'un signal de commande $C_{LO}$ allant vers l'oscillateur local variable 346. Par exemple, l'oscillateur local variable est un VCO (oscillateur contrôlé en tension). De tels oscillateurs sont par exemple décrits plus en détail dans la publication IEEE intitulée "A 2.6 GHz/5.2 GHz CMOS Voltage-controlled Oscillator", C. Lam et al., et dans la publication IEEE intitulée "Multi-band Multi-standard Local Oscillator Generation for Direct up/down Conversion Transceiver Architectures Supporting Wifi and WiMax Bands in Standard 45 nm CMOS Process", R. Sadhwani et al., le contenu des deux publications étant considéré ici comme connu.

Un bloc de commande (CTRL) 348 reçoit un signal de sélection SEL, indiquant une norme de communication à utiliser pour la transmission des signaux de données. Le signal de sélection SEL est par exemple fourni par le processeur de bande de base du dispositif mobile 100. Sur la base du signal de sélection SEL, le bloc de commande 348 génère les signaux de commande $C_{FIL}$, $C_{LO}$ et $C_{FIR}$ pour contrôler les filtres 308, 310, l'oscillateur local variable 346 et les filtres FIR variables 334, 336 respectivement. Par exemple, le circuit de commande 348 comprend une mémoire mémorisant les paramètres de commande optimum pour chacune des normes prises en charge.

Ainsi, en fonctionnement, en fonction de la norme de communication sélectionnée, les filtres 308, 310 sont choisis pour avoir des fréquences de coupure appropriées, qui dépendent par exemple du débit de données des signaux de données conformément à la norme de communication sélectionnée. En outre, les fréquences des signaux de fréquence $LO_I$ et $LO_Q$ sont adaptées en fonction de la norme de communication sélectionnée. En outre, les fréquences de coupure des filtres FIR variables 334, 336 sont choisies en fonction des composantes des canaux principal et adjacent du signal d'émission selon la norme de communication sélectionnée.

Les caractéristiques, comme le gain, de l'amplificateur de puissance 316 ne sont par exemple pas changées en fonction de la norme de communication sélectionnée. Au lieu de cela, le chemin de contre-réaction fourni par l'atténuateur 320 par l'intermédiaire des filtres FIR variables 334, 336 assure une pré-distorsion sur les signaux de données d'entrée, améliorant ainsi la linéarité du signal de sortie sans qu'aucun changement ne soit appliqué à l'amplificateur de puissance.

L'amplificateur de puissance 316 et/ou les mélangeurs 312, 314 sont par exemple choisis de façon à avoir un gain relativement élevé sur une grande largeur de bande, et en particulier un gain relativement élevé pour toutes les plages de fréquences qui peuvent être présentes lorsque chacune des normes de communication est appliquée.

Les mélangeurs 312, 314, 322, 324 et les filtres passe-bas 308, 310, 326 et 328 sont par exemple mis en oeuvre par des dispositifs passifs, et par conséquent ils consomment relativement peu d'énergie.

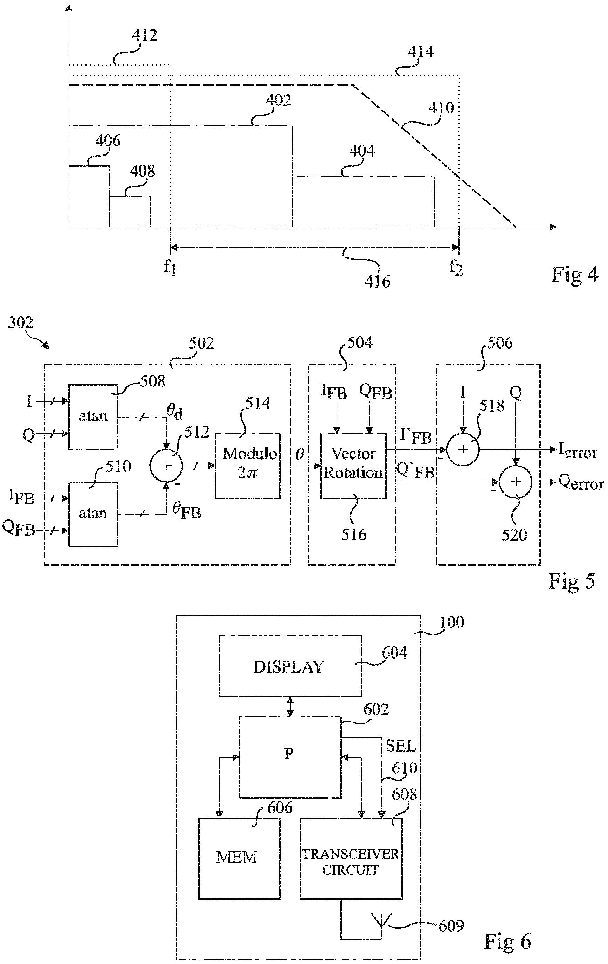

La figure 4 illustre un exemple de fréquences présentes dans le chemin de contre-réaction de la figure 3. Les composantes de signal 402 et 404 représentent les parties des canaux principal et adjacent du signal de sortie sur la ligne 318 selon un exemple dans lequel les signaux correspondent à la norme LTE. Les composantes de signal 406 et 408 représentent les parties des canaux principal et adjacent du signal de sortie sur la ligne 318 selon un autre exemple dans lequel les signaux correspondent à la norme GSM.

Un exemple des caractéristiques des filtres passe-bas 326 et 328 est représenté par la ligne en trait interrompu 410 en figure 4, et la fréquence de coupure de ces filtres est choisie pour englober les canaux principaux et adjacents de toutes les composantes de signal 402 à 408 des deux exemples de normes de communication.

Un exemple des caractéristiques des filtres FIR variables 334, 336 est représenté par la ligne en pointillés 412, d'après laquelle la fréquence de coupure $f_1$ est choisie légèrement supérieure à la fréquence la plus élevée de la composante de la bande latérale haute 408. Un autre exemple des caractéristiques des filtres FIR variables 334, 336 est représenté par la ligne en pointillés 414, d'après laquelle une fréquence de coupure $f_2$ est choisie légèrement supérieure à la fréquence la plus élevée de la composante de la bande latérale haute 404. Ainsi, la fréquence de coupure du filtre FIR est par exemple variable dans une plage comprise entre les fréquences $f_1$ et $f_2$, comme cela est représenté par une flèche 416.

Dans un exemple, on suppose que la fréquence de la composante de canal principal 406 est de l'ordre de 100 kHz, la fréquence de coupure associée $f_1$ des filtres FIR variables 334, 336 est dans la région des 140 kHz, incluant ainsi le canal adjacent 408. On suppose que la fréquence de la composante de canal principal 402 est de l'ordre de 10 MHz, que la fréquence de coupure associée $f_2$ des filtres FIR variables 334, 336 est dans la région des 15 MHz, incluant ainsi le canal adjacent 404.

La figure 5 illustre plus en détail le bloc numérique 302 de la figure 3 selon un exemple. Comme cela est illustré, la partie numérique comprend trois modules principaux, un module de détection de phase 502, un module de rotation de phase 504 et un module de soustraction 506.

Le module de détection de phase 502 comprend par exemple un bloc de fonction Arc tangente (atan) 508, qui reçoit les signaux de données d'entrée I et Q, et un bloc de fonction Arc tangente (atan) 510, qui reçoit les signaux de contre-réaction $I_{FB}$ et $Q_{FB}$ provenant des filtres FIR 334, 336 de la figure 3. La fonction Arc tangente des blocs 508, 510 est par exemple mise en oeuvre par une table de conversion, ou par un algorithme CORDIC (calculateur numérique de rotation de coordonnées). Dans le cas d'une table de conversion, le signal I est par exemple divisé par le signal Q, ou vice-versa, et le résultat fournit l'entrée de la table de conversion. La table de conversion a par exemple la forme d'une table d'interpolation, mémorisant des valeurs de la fonction Arc tangente. A titre de variante, dans le cas d'une solution CORDIC, on met en oeuvre un algorithme itératif qui prend en entrée les deux coordonnées du vecteur du signal I ou Q, et fournit en sortie la phase correspondante.

Les valeurs de phase $\theta_d$ et $\theta_{FB}$ générées par les blocs de fonction Arc tangente 508, 510 respectivement sont fournies à un soustracteur 512, qui soustrait la phase $\theta_{FB}$ de la phase $\theta_d$. La sortie du soustracteur 512 est par exemple couplée à un bloc de modulo $2\pi$ 514, qui normalise la sortie du soustracteur 512 pour empêcher un débordement, et pour fournir un signal $\theta$ approprié pour le module de rotation de phase 504.

Le module de rotation de phase 504 comprend un bloc de rotation de vecteur (Vector Rotation) 516, qui reçoit la valeur de phase $\theta$ provenant du bloc 502, accompagnée des signaux de contre-réaction $I_{FB}$ et $Q_{FB}$, et modifie la phase des signaux de contre-réaction sur la base de la valeur de phase $\theta$. Par exemple, le module de rotation de phase 504 applique l'équation suivante :

$$\begin{bmatrix} I_{FB}' \\ Q_{FB}' \end{bmatrix} = \begin{bmatrix} \cos(\theta) - \sin(\theta) \\ \sin(\theta) & \cos(\theta) \end{bmatrix} \begin{bmatrix} I_{FB} \\ Q_{FB} \end{bmatrix}$$

où $I_{FB}'$ et $Q_{FB}'$ sont les valeurs de contre-réaction à phase modifiée, et $\theta$ est la valeur de phase fournie par le module d'estimation de phase 502. Cette équation pourrait par exemple être mise en oeuvre en utilisant des tables de conversion et une multiplication complexe. A titre de variante, la rotation de phase pourrait être mise en oeuvre par un algorithme CORDIC sans utiliser de multiplieurs.

Les signaux de contre-réaction à phase ajustée $I_{FB}'$ et $Q_{FB}'$ sont fournis au bloc de soustraction 506, et en particulier à des soustracteurs 518 et 520 respectivement, qui soustraient ces signaux de contre-réaction des signaux I et Q, pour fournir les signaux d'erreur $I_{error}$ et $Q_{error}$. Il sera clair pour l'homme de l'art que tous les soustracteurs décrits ici peuvent être mis en oeuvre en pratique en générant le complément à deux des valeurs à soustraire, puis en réalisant une addition.

La figure 6 illustre plus en détail le dispositif mobile 100 de la figure 1 selon un mode de réalisation dans lequel il comprend un bloc de traitement P 602, qui est par exemple le processeur de bande de base du dispositif mobile, et communique avec un certain nombre de composants, tels qu'un afficheur (DISPLAY) 604, une mémoire (MEM) 606 et un circuit émetteur-récepteur (TRANSCEIVER CIRCUIT) 608. Le circuit émetteur-récepteur 608 comprend par exemple le circuit d'émission de la figure 3, et comprend aussi une antenne 609 pour émettre le signal produit. En outre, le circuit émetteur-récepteur 608 reçoit par exemple un signal de sélection SEL sur une ligne 610 provenant du processeur 602, qui indique selon quelle norme parmi les normes de communication prises en charge les données doivent être transmises. Par exemple, l'utilisateur du dispositif mobile 100 peut choisir de changer de norme de communication, par exemple pour économiser l'énergie de la batterie. Par exemple, par l'intermédiaire de l'interface utilisateur du dispositif mobile 100, l'utilisateur sélectionne la norme de communication à appliquer. A titre de variante, la station de base à laquelle est connecté le dispositif mobile 100 peut sélectionner le mode de communication, par exemple sur la base de divers facteurs comme le fait que la norme de communication soit surchargée ou pas.

Le dispositif mobile 100 est par exemple un téléphone mobile, un téléphone intelligent, un ordinateur portable ou une tablette, une console de jeu portable, une caméra numérique ou un autre dispositif électronique capable de communications sans fil selon une pluralité de normes de communication.

Avec la description ainsi faite d'au moins un mode de réalisation illustratif de l'invention, divers changements, diverses modifications et améliorations apparaitront facilement à l'homme de l'art.

Par exemple, bien qu'on ait prévu les normes de communication GSM, UMTS, WiMax et LTE à titre d'exemple, il sera clair pour l'homme de l'art que le circuit d'émission 300 de la figure 3 pourrait prendre en charge toute combinaison de ces normes, et/ou d'autres normes telles que la norme Wifi (fidélité sans fil), ou la norme Bluetooth.

En outre, bien qu'on ait décrit l'exemple de filtres FIR variables 334, 336 en relation avec la figure 3, il sera clair pour l'homme de l'art que dans des variantes de réalisation on pourrait utiliser d'autres types de filtres passe-bas numériques. Un avantage de la mise en oeuvre de ces filtres sous forme de filtres numériques est qu'on peut obtenir une fonction de filtrage précise.

En outre, il sera clair pour l'homme de l'art que, bien que les composants du bloc 302 de la figure 3 aient été décrits comme étant mis en oeuvre sous forme numérique, dans des variantes de réalisation on pourrait mettre en oeuvre une ou plusieurs des fonctions de ce bloc par des composants analogiques, et vice-versa pour les filtres analogiques 308, 310 et 326, 328.

## Revendications

1. Circuit d'émission RF sans fil multistandard comprenant :

un circuit d'entrée (302 à 314) pour générer un signal d'émission ($I_T(t)$, $Q_T(t)$) sur la base d'un signal de données d'entrée (I, Q) ;
un amplificateur de puissance (316) adapté à amplifier le signal d'émission pour fournir un signal de sortie (S(t)) pour émission par l'intermédiaire d'au moins une antenne (609) ; et
un circuit de contre-réaction (320 à 340) comprenant au moins un filtre passe-bas variable (334, 336) pour générer un signal de contre-réaction ($I_{FB}$, $Q_{FB}$) sur la base du signal de sortie, le circuit d'entrée comprenant en outre un circuit de pré-distorsion (302) adapté à modifier le signal de données d'entrée (I, Q) sur la base du signal de contre-réaction.

2. Circuit selon la revendication 1, comprenant en outre :

un circuit de commande (348) adapté à contrôler une fréquence de coupure dudit au moins un filtre passe-bas variable sur la base d'une norme de communication sélectionnée pour l'émission RF sans fil.

3. Circuit selon la revendication 1 ou 2, comprenant en outre un oscillateur variable (346) pour générer au moins un signal de fréquence ($LO_I$, $LO_Q$) sur la base d'une norme de communication sélectionnée pour l'émission RF sans fil, et dans lequel :

le circuit d'entrée comprend en outre au moins un mélangeur (312, 314) adapté à réaliser une élévation de fréquence du signal de données d'entrée modifié sur la base dudit signal de fréquence pour générer le signal d'émission ;
le circuit de contre-réaction comprenant en outre au moins un mélangeur (322, 324) adapté à réaliser un abaissement de fréquence du signal d'émission avant le filtrage par le filtre passe-bas.

4. Circuit selon l'une quelconque des revendications 1 à 3, dans lequel ledit au moins un filtre passe-bas variable est un filtre numérique.

**5.** Circuit selon l'une quelconque des revendications 1 à 4, dans lequel le signal de données d'entrée comprend une composante en phase (I) et une composante en quadrature (Q).

**6.** Circuit selon l'une quelconque des revendications 1 à 5, dans lequel le circuit d'entrée comprend en outre au moins un convertisseur numérique-analogique (304, 306) pour convertir le signal de données d'entrée modifié, et dans lequel le circuit de contre-réaction comprend au moins un convertisseur analogique-numérique (330, 332) pour convertir le signal de sortie avant le filtrage par le filtre passe-bas.

**7.** Circuit selon l'une quelconque des revendications 1 à 6, dans lequel le circuit d'entrée comprend en outre au moins un filtre passe-bas variable analogique (308, 310) adapté à filtrer le signal de données d'entrée modifié.

**8.** Circuit selon l'une quelconque des revendications 1 à 7, dans lequel le circuit de contre-réaction comprend en outre au moins un filtre passe-bas analogique (326, 328) à fréquence de coupure fixe pour filtrer le signal de sortie avant le filtrage par le filtre passe-bas variable.

**9.** Circuit selon l'une quelconque des revendications 1 à 8, dans lequel le circuit de contre-réaction comprend en outre un atténuateur (320) adapté à atténuer le signal de sortie avant le filtrage par le filtre passe-bas variable.

**10.** Circuit selon l'une quelconque des revendications 1 à 9, dans lequel le circuit de pré-distorsion comprend en outre au moins un déphaseur (338, 340) pour modifier la phase du signal de contre-réaction, et au moins un soustracteur (342, 344) adapté à soustraire le signal de contre-réaction à phase modifiée du signal de données d'entrée.

**11.** Circuit selon l'une quelconque des revendications 1 à 10, dans lequel ledit au moins un filtre passe-bas variable du circuit de contre-réaction est un filtre FIR (à réponse impulsionnelle finie).

**12.** Dispositif mobile comprenant :

un bloc processeur (602) ; et
un circuit émetteur-récepteur (608) comprenant le circuit de l'une quelconque des revendications 1 à 11, dans lequel le bloc processeur (602) est agencé pour générer un signal de sélection (SEL) indiquant une norme de communication sélectionnée pour la transmission RF sans fil.

**13.** Dispositif mobile selon la revendication 12, comprenant en outre au moins une antenne agencée pour émettre le signal de sortie (S(t)).

**14.** Procédé d'émission RF sans fil multistandard comprenant les étapes suivantes :

générer, par un circuit d'entrée (302 à 314), un signal d'émission ($I_T(t)$, $Q_T(t)$) sur la base d'un signal de données d'entrée (I, Q) ;
amplifier le signal d'émission par un amplificateur de puissance (316) pour fournir un signal de sortie (S(t)) pour émission par l'intermédiaire d'au moins une antenne (609) ;
générer, par au moins un filtre passe-bas variable (334, 336), un signal de contre-réaction ($I_{FB}$, $Q_{FB}$) sur la base du signal de sortie ; et
modifier, par un circuit de pré-distorsion (302), le signal de données d'entrée (I, Q) sur la base du signal de contre-réaction.

**15.** Procédé selon la revendication 14, comprenant en outre la commande d'une fréquence de coupure dudit au moins un filtre passe-bas variable sur la base d'une norme de communication sélectionnée pour l'émission RF sans fil.

Fig 1

Fig 2

Fig 3

Fig 4

Fig 5

Fig 6

**EP 2 533 428 A1**

Europäisches
Patentamt

European
Patent Office

Office européen
des brevets

# RAPPORT DE RECHERCHE EUROPEENNE

Numéro de la demande

EP 12 16 2528

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | WO 2008/089176 A1 (NEXTWAVE BROADBAND INC [US]; GUMMADI SRIKANTH [US]; WANG LEI [US]; HOS) 24 juillet 2008 (2008-07-24) * le document en entier * ----- | 1-15 | INV. H04B1/04 H03F1/32 |
| A | US 2009/042521 A1 (OTAKA SHOJI [JP] ET AL) 12 février 2009 (2009-02-12) * alinéa [0036] - alinéa [0045]; figure 1 * ----- | 1-15 | |
| A | HYUNCHOL SHIN ET AL: "A CMOS Active- RC Low-Pass Filter With Simultaneously Tunable High- and Low-Cutoff Frequencies for IEEE 802.22 Applications", IEEE TRANSACTIONS ON CIRCUITS AND SYSTEMS II: EXPRESS BRIEFS, IEEE, US, vol. 57, no. 2, 1 février 2010 (2010-02-01), pages 85-89, XP011334157, ISSN: 1549-7747, DOI: 10.1109/TCSII.2009.2037994 * le document en entier * ----- | 1-15 | |
| | | | DOMAINES TECHNIQUES RECHERCHES (IPC) |
| A | RAM SADHWANI ET AL: "Multi-band multi-standard local oscillator generation for direct up/down conversion transceiver architectures supporting WiFi and WiMax bands in standard 45nm CMOS process", RADIO FREQUENCY INTEGRATED CIRCUITS SYMPOSIUM (RFIC), 2010 IEEE, IEEE, PISCATAWAY, NJ, USA, 23 mai 2010 (2010-05-23), pages 149-152, XP031684091, ISBN: 978-1-4244-6240-7 * le document en entier * ----- | 1-15 | H04B H03F |

Le présent rapport a été établi pour toutes les revendications

| Lieu de la recherche | Date d'achèvement de la recherche | Examinateur |
|---|---|---|
| La Haye | 26 avril 2012 | Andersen, Jan |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 12 16 2528

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

26-04-2012

| Document brevet cité au rapport de recherche | Date de publication | Membre(s) de la famille de brevet(s) | | Date de publication |
|---|---|---|---|---|
| WO 2008089176 A1 | 24-07-2008 | CA | 2691224 A1 | 24-07-2008 |
| | | CN | 101690368 A | 31-03-2010 |
| | | EP | 2116083 A1 | 11-11-2009 |
| | | US | 2008176523 A1 | 24-07-2008 |
| | | WO | 2008089176 A1 | 24-07-2008 |
| US 2009042521 A1 | 12-02-2009 | CN | 101364968 A | 11-02-2009 |
| | | JP | 4468422 B2 | 26-05-2010 |
| | | JP | 2009044525 A | 26-02-2009 |
| | | US | 2009042521 A1 | 12-02-2009 |

EPO FORM P0460

Pour tout renseignement concernant cette annexe : voir Journal Officiel de l'Office européen des brevets, No.12/82

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **H. SHIN.** A CMOS Active-RC Low Pass Filter With Simultaneous Tunable High- and Low-cutoff Frequencies for IEEE 802.22 Applications. *IEEE*
- **T.K. SHAHANNA.** *GUI Based Decimation Filter Design Tool for Multi-Standard Wireless Transceivers*
- **C. LAM.** A 2.6 GHz/5.2 GHz CMOS Voltage-controlled Oscillator. *IEEE*
- **R. SADHWANI.** Multi-band Multi-standard Local Oscillator Generation for Direct up/down Conversion Transceiver Architectures Supporting Wifi and WiMax Bands in Standard 45 nm CMOS Process. *IEEE*